# EUROPEAN PATENT APPLICATION

(11) **EP 1 763 077 A2**
(43) Date of publication of application: **14.03.2007**
(21) Application number: 06018784.6
(22) Date of filing: 07.09.2006
(51) Int. Cl.: H01L 23/485

(54) **Semiconductor device**

(30) Priority: 13.09.2005 JP 2005265481
(71) Applicant: SEIKO EPSON CORPORATION, Shinjuku-ku, Tokyo 163-0811 (JP)
(72) Inventor: Hashimoto, Nobuaki, Suwa-shi Nagano-ken 392-8502 (JP)
(74) Representative: HOFFMANN EITLE

(57) **Abstract**

A semiconductor device including: a semiconductor chip in which an integrated circuit is formed; a plurality of electrodes formed on the semiconductor chip and arranged in a plurality of rows and a plurality of columns; a plurality of resin protrusions formed on a surface of the semiconductor chip on which the electrodes are formed; and a plurality of electrical connection sections formed on the resin protrusions.

## Description

### BACKGROUND OF THE INVENTION

The present invention relates to a semiconductor device.

In order to reduce the size of electronic parts, it is desirable that a semiconductor device have a small external shape. Along with diversification of the functions of semiconductor devices, the degree of integration of an integrated circuit formed on a semiconductor chip has been increased. Specifically, a semiconductor device has been developed which can satisfy demands for a reduction in size of a semiconductor device and an increase in degree of integration of an integrated circuit.

As a semiconductor device which can satisfy such demands, a semiconductor device has attracted attention which has an external shape almost equal to that of a semiconductor chip (see JP-A-2-272737). According to this type of semiconductor device, the size of the semiconductor device can be reduced by reducing the size of the semiconductor chip.

In order to ensure the reliability of a semiconductor device, an integrated circuit is designed under various limitations. A reduction in the limitations to the integrated circuit design allows a reduction in the integrated circuit region, whereby the size of the semiconductor chip can be reduced. Specifically, a semiconductor device with a small external shape can be manufactured by utilizing a semiconductor chip with reduced limitations to the integrated circuit design.

### SUMMARY

According to one aspect of the invention, there is provided a semiconductor device comprising:
a semiconductor chip in which an integrated circuit is formed;
a plurality of electrodes formed on the semiconductor chip and arranged in a plurality of rows and a plurality of columns;
a plurality of resin protrusions formed on a surface of the semiconductor chip on which the electrodes are formed; and
a plurality of electrical connection sections formed on the resin protrusions and electrically connected to the electrodes.

### BRIEF DESCRIPTION OF THE SEVERAL VIEWS OF THE DRAWING

FIG. 1 is a view illustrative of a semiconductor device according to one embodiment of the invention.
FIG. 2 is a view illustrative of a semiconductor device according to one embodiment of the invention.
FIG. 3 is a view illustrative of a semiconductor device according to one embodiment of the invention.
FIG. 4 is a view illustrative of a semiconductor device according to one embodiment of the invention.
FIG. 5 is a view illustrative of a semiconductor device according to one embodiment of the invention.
FIG. 6 is a view illustrative of a semiconductor device according to a modification of one embodiment of the invention.

### DETAILED DESCRIPTION OF THE EMBODIMENT

The invention may provide a semiconductor device which can be reduced in size and exhibits high reliability.
(1) According to one embodiment of the invention, there is provided a semiconductor device comprising:
   a semiconductor chip in which an integrated circuit is formed;
   a plurality of electrodes formed on the semiconductor chip and arranged in a plurality of rows and a plurality of columns;
   a plurality of resin protrusions formed on a surface of the semiconductor chip on which the electrodes are formed; and
   a plurality of electrical connection sections formed on the resin protrusions and electrically connected to the electrodes.
   According to this embodiment, a semiconductor device can be provided which can be reduced in size and exhibits high reliability.
(2) In this semiconductor device, the electrodes may be disposed at intersection points of first imaginary straight lines extending in parallel with one another and second imaginary straight lines perpendicularly intersecting the first imaginary straight lines.
(3) In this semiconductor device,
   the semiconductor chip may have a rectangular external shape; and
   the first and second imaginary straight lines may be parallel to long or short sides of the semiconductor chip.
(4) In this semiconductor device,
   the semiconductor chip may have a rectangular external shape; and
   the resin protrusions may extend in parallel to long or short sides of the semiconductor chip.
(5) In this semiconductor device, one of the resin protrusions may be provided near one of the sides of the semiconductor chip.
(6) In this semiconductor device, two or more of the resin protrusions may be provided near one of the sides of the semiconductor chip.
(7) In this semiconductor device,
   a plurality of I/O cells arranged in a plurality of rows and a plurality of columns may be formed on the semiconductor chip; and
   each of the electrodes may be electrically connected to one of the I/O cells.
   According to the above features, the integrated circuit region of the semiconductor chip can be reduced. As a result, a semiconductor chip with a small external shape can be utilized, whereby the size of the semiconductor device can be further reduced.
(8) In this semiconductor device, each of the electrodes may cover at least part of corresponding one of the I/O cells.
   This allows provision of a semiconductor device which can be further reduced in size.
(9) In this semiconductor device, the electrodes may cover at least part of the integrated circuit.

Embodiments of the invention will be described below with reference to the drawings. Note that the invention is not limited to the following embodiments. The invention also includes a configuration in which the following embodiments and modifications are arbitrarily combined.

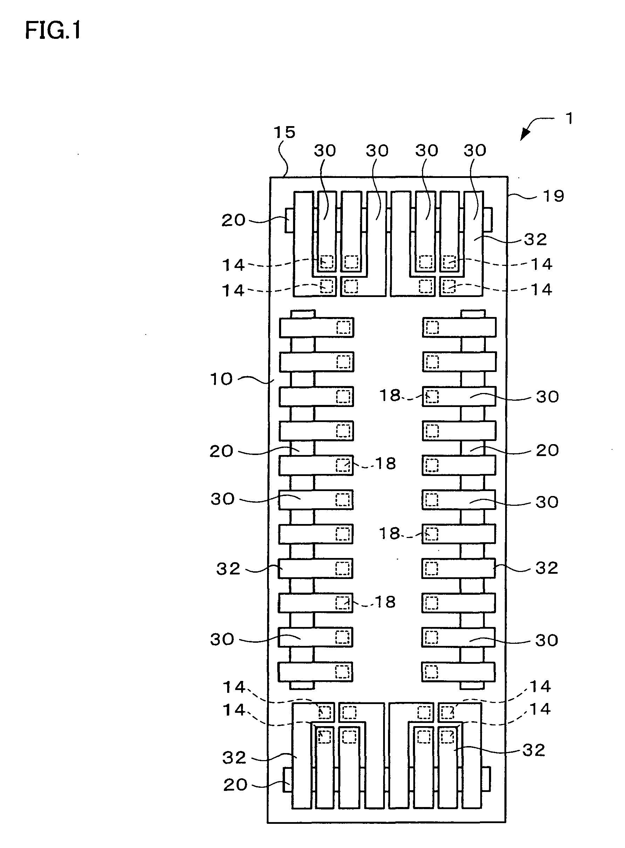

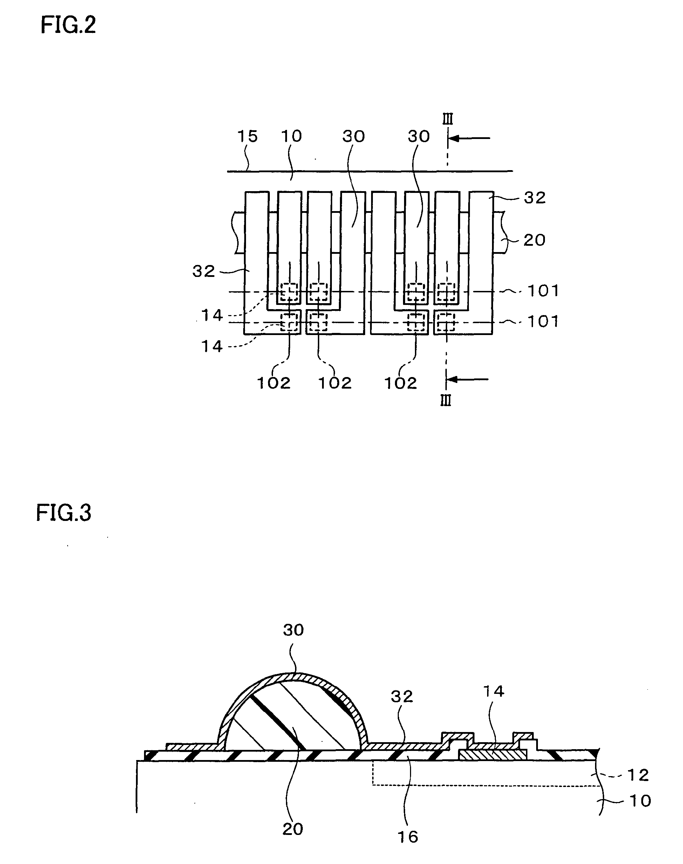

A semiconductor device according to an embodiment to which the invention is applied is described below with reference to FIGS. 1 to 3. FIG 1 is a schematic view of a semiconductor device 1 according to an embodiment to which the invention is applied. FIG 2 is a partially enlarged view of FIG. 1. FIG 3 is a partially enlarged view along the line III-III in FIG 2.

As shown in FIGS. 1 and 3, the semiconductor device according to this embodiment includes a semiconductor chip 10. The semiconductor chip 10 may be a silicon substrate or the like. An integrated circuit 12 may be formed on the semiconductor chip 10 (see FIG. 3). The configuration of the integrated circuit 12 is not particularly limited. For example, the integrated circuit 12 may include an active element such as a transistor and a passive element such as a resistor, coil, or capacitor. The surface (active surface) of the semiconductor chip 10 on which the integrated circuit 12 is formed may be rectangular (see FIG. 1). The active surface of the semiconductor chip 10 may be square (not shown).

As shown in FIGS. 1 to 3, the semiconductor device according to this embodiment includes a plurality of electrodes 14. The electrodes 14 are arranged in rows and columns. For example, the electrodes 14 may be arranged in a lattice. As shown in FIG. 2, the electrodes 14 may be disposed at the intersection points of first imaginary straight lines 101 extending in parallel and second imaginary straight lines 102 extending to intersect the first imaginary straight lines 101. The first and second imaginary straight lines 101 and 102 may perpendicularly intersect. The first and second imaginary straight lines 101 and 102 may be straight lines extending parallel to the sides of the semiconductor chip 10. As shown in FIGS. 1 and 2, the first imaginary straight line 101 may extend parallel to a side 15 of the semiconductor chip 10, for example. In this case, the side 15 of the semiconductor chip 10 may be the short side of the active surface of the semiconductor chip 10. The electrodes 14 may be formed in the peripheral region of the side 15. As shown in FIGS. 1 and 2, the electrodes 14 may be arranged in four rows and two columns, for example. Note that the semiconductor device according to this embodiment is not limited thereto. The electrodes 14 may be arranged in M rows and N columns (M and N are integers greater than one). The electrodes 14 may be randomly disposed. Specifically, the electrodes 14 may be irregularly arranged. The electrode 14 may be formed directly over the integrated circuit element formed in the semiconductor chip 10.

The electrode 14 may be formed to overlap at least part of the integrated circuit 12 (circuit element of the integrated circuit 12). The electrode 14 may be electrically connected with the integrated circuit 12 (circuit element of the integrated circuit 12). The electrode 14 may be electrically connected with an I/O cell formed on the semiconductor chip 10. In this case, the electrodes 14 may be formed on the corresponding I/O cells, respectively. The I/O cells may be arranged in rows and columns.

The electrode 14 may be part of an internal interconnect (or an electrode of the circuit element) of the semiconductor chip. The electrode 14 may be formed of a metal such as aluminum or copper. A passivation film 16 may be formed on the semiconductor chip 10. In this case, the passivation film 16 may be formed to expose the electrode 14 (see FIG. 3). The passivation film may be an inorganic insulating film formed of SiO₂, SiN, or the like. The passivation film 16 may be an organic insulating film formed of a polyimide resin or the like.

As shown in FIG. 1, the semiconductor device according to this embodiment may include electrodes 18. The electrodes 18 may be arranged along a side 19 adjacent to the side 15. The electrodes 18 may be arranged in line along the side 19. The electrodes 18 may be arranged in rows and columns along the side 19.

As shown in FIGS. 1 to 3, the semiconductor device according to this embodiment includes a resin protrusion 20 formed on the semiconductor chip 10. The resin protrusion 20 is formed on the surface of the semiconductor chip 10 on which the electrodes 14 are formed. Specifically, the resin protrusion 20 may be formed on the active surface of the semiconductor chip 10. The resin protrusion 20 may be formed on the passivation film 16. The resin protrusion 20 may be formed not to overlap the integrated circuit 12. The resin protrusion 20 may be formed to avoid (expose) the electrodes 14 and 18. The resin protrusion 20 may be disposed between the electrodes 14 and the side 15. The resin protrusion 20 may be disposed between the electrodes 18 and the side 19. Specifically, the resin protrusions 20 may be formed on the active surface of the semiconductor chip 10 in regions outside the electrodes 14 and 18. Note that the semiconductor device according to this embodiment is not limited thereto. For example, the resin protrusion 20 may be formed in a region inside the electrodes. The resin protrusion 20 may be disposed between the electrodes 14. Specifically, the electrodes 14 may be disposed on either side of the resin protrusion 20. In this case, an interconnect 32 described later may extend toward both sides of the resin protrusion 20. In other words, the interconnect 32 may extend from both sides of the resin protrusion 20.

The material for the resin protrusion 20 is not particularly limited. A known material may be used. For example, the resin protrusion 20 may be formed of a resin such as a polyimide resin, silicone-modified polyimide resin, epoxy resin, silicone-modified epoxy resin, benzocyclobutene (BCB), polybenzoxazole (PBO), or phenol resin. The shape of the resin protrusion 20 is not particularly limited. For example, the resin protrusion 20 may be formed linearly (see FIG. 1). In this case, the resin protrusion 20 may be formed to extend along the side of the semiconductor chip 10 (active surface of the semiconductor chip 10). The resin protrusions 20 may be respectively formed along the sides of the semiconductor chip 10. Or, a plurality of resin protrusions 20 may be formed along one side of the active surface (not shown). The surface of the resin protrusion 20 may be curved. In this case, the cross-sectional shape of the resin protrusion 20 may be a semicircle, as shown in FIG. 3. The resin protrusion 20 may have a hemispherical shape (not shown).

The semiconductor device according to this embodiment includes a plurality of electrical connection sections 30. The electrical connection section 30 is formed on the resin protrusion 20. The electrical connection sections 30 are electrically connected with the electrodes 14, respectively. For example, the electrical connection section 30 may refer to part (region overlapping the resin protrusion 20) of the interconnect 32 which is pulled from the electrode 14 and extends over the resin protrusion 20. In this case, the electrical connection section 30 may refer to part of the interconnect 32 utilized for electrical connection with the outside. As shown in FIGS. 1 and 2, a plurality of electrical connection sections 30 may be formed on one resin protrusion 20. In this case, the electrical connection sections 30 electrically connected with the electrodes 14 may be formed on the resin protrusions 20 in a number less than the number of rows or the number of columns of the electrodes 14. Specifically, when the electrical connection sections 30 formed on one resin protrusion 20 make up one group, the electrical connection sections 30 electrically connected with the electrodes 14 may be formed so that the electrical connection sections 30. can be divided into groups in a number less than the number of rows or the number of columns of the electrodes 14. For example, when the resin protrusion 20 has a shape extending parallel to the first imaginary straight line 101, the number of resin protrusions 20 may be less than the number of first imaginary straight lines 101.

The structure and the material for the interconnect 32 (electrical connection section 30) are not particularly limited. For example, the interconnect 32 may be formed of a single layer. Or, the interconnect 32 may be formed of a plurality of layers. In this case, the interconnect 32 may include a first layer formed of titanium tungsten and a second layer formed of gold (not shown).

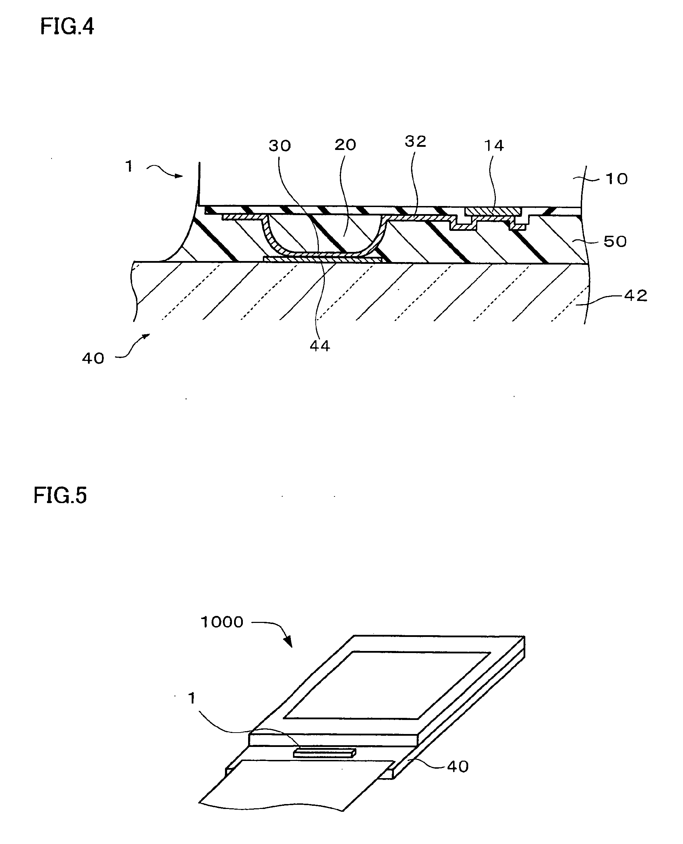

The semiconductor device 1 according to this embodiment may have the above-described configuration. FIG. 4 illustrates a state in which the semiconductor device 1 is mounted on an interconnect substrate 40. The configuration illustrated in FIG. 4 is described below in detail.

The interconnect substrate 40 is described below. The interconnect substrate 40 may include a base substrate 42 and an electrical connection section 44. The electrical connection section 44 may refer to part of an interconnect pattern of the interconnect substrate 40. Specifically, the electrical connection section 44 may refer to part of the interconnect pattern of the interconnect substrate 40 utilized for electrical connection with the outside. The material for the base substrate 42 is not particularly limited. A substrate formed of an inorganic material may be used as the base substrate 42. In this case, the base substrate 42 may be a ceramic substrate or a glass substrate. When the base substrate 42 is a glass substrate, the interconnect substrate 40 may be part of an electro-optical panel (e.g. liquid crystal panel or electroluminescent panel). In this case, the electrical connection section 44 may be formed of a metal film or a metal compound film such as indium tin oxide (ITO), Cr, or Al, or a composite of these films. The electrical connection section 44 may be electrically connected with an electrode (e.g. scan electrode, signal electrode, or common electrode) which drives a liquid crystal. The base substrate 42 may be a substrate or a film formed of polyethylene terephthalate (PET). A flexible substrate formed of a polyimide resin may be used as the base substrate 42. A tape used in the flexible printed circuit (FPC) or tape automated bonding (TAB) technology may be used as the flexible substrate. In this case, the electrical connection section 44 may be formed by stacking any of copper (Cu), chromium (Cr), titanium (Ti), nickel (Ni), and titanium tungsten (Ti-W), for example.

The semiconductor device 1 may be mounted so that the active surface of the semiconductor chip 10 faces the interconnect substrate 40. In this case, the electrical connection section 44 of the interconnect substrate 40 and the electrical connection section 30 may be in contact and be electrically connected. In more detail, the electrical connection section 30 of the semiconductor device 1 may be in contact and be electrically connected with the electrical connection section 44 of the interconnect substrate 40. This allows the electrical connection section 30 to be pressed against the electrical connection section 44 due to the elasticity of the resin protrusion 20. Therefore, a semiconductor device with excellent electrical connection reliability can be provided. The semiconductor device 1 may be bonded to the interconnect substrate 40 using an adhesive 50. The semiconductor device 1 may adhere to the interconnect substrate 40 through the adhesive 50. The resin protrusion 20 may be maintained in an elastically deformed state by maintaining the semiconductor device 1 and the interconnect substrate 40 at a specific interval using the adhesive 50. The semiconductor device 1 may be directly mounted on a glass substrate of an electronic module 1000. In this case, the semiconductor device 1 may be mounted on the glass substrate using a chip on glass (COG) mounting method.

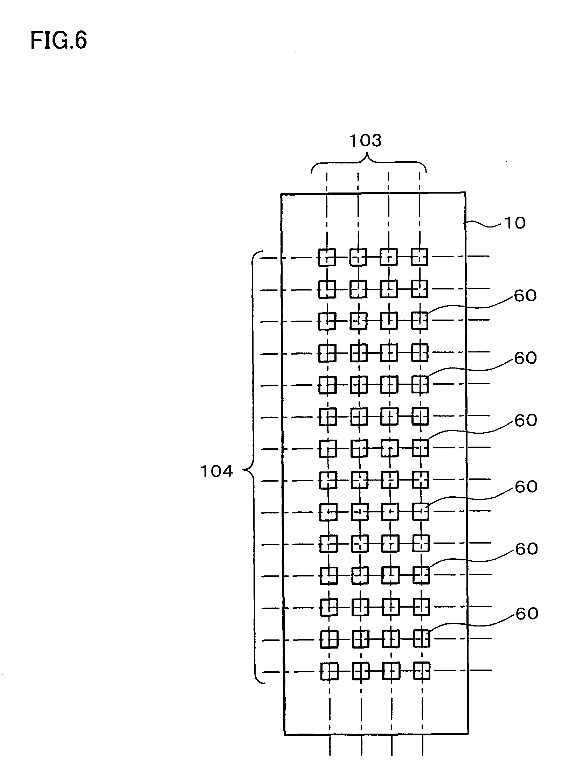

FIG. 5 illustrates the electronic module 1000 on which the semiconductor device 1 is mounted. The electronic module 1000 may be a display device. The display device may be a liquid crystal display device, an electroluminescent (EL) display device, or the like. The semiconductor device 1 may be a driver IC which controls the display device.

According to the semiconductor device 1, a semiconductor device can be provided which can be reduced in size and exhibits high reliability. The reasons therefor are described below in detail.

According to related-art technology, a force may be applied to the electrode when mounting the semiconductor device. When the electrode is disposed to overlap the integrated circuit 12, the characteristics of the integrated circuit 12 may change due to the force applied to the electrode. In order to prevent such a problem, internal interconnects have been provided in the semiconductor chip so that the electrode does not overlap the integrated circuit. However, it becomes difficult to provide the internal interconnects as the semiconductor device is scaled down and the degree of integration of the integrated circuit is increased. It is expected that the design of the integrated circuit 12 is limited due to the limitations to the internal interconnects.

In the semiconductor device 1, the electrical connection section 30 is utilized as the external terminal, as described above. The electrical connection section 30 is formed on the resin protrusion 20. Therefore, the semiconductor device 1 can be mounted without applying a force to the electrode 14. As a result, this embodiment allows provision of a semiconductor device in which the characteristics of the integrated circuit 12 do not change during mounting even if the electrode 14 is formed on the integrated circuit 12. Specifically, this embodiment ensures the reliability of the semiconductor device even when utilizing a semiconductor chip in which the electrode 14 is disposed to overlap the integrated circuit 12.

Accordingly, this embodiment can provide a semiconductor device which allows utilization of a semiconductor chip in which limitations to the design of the integrated circuit 12 are reduced (i.e. the degrees of freedom of the design of the integrated circuit 12 are increased). An increase in the degrees of freedom of the design of the integrated circuit allows a reduction in the external shape of the semiconductor chip. In particular, the external shape of the semiconductor chip can be further reduced by disposing the electrode directly over the integrated circuit. Therefore, this embodiment can provide a semiconductor device which allows utilization of a semiconductor chip with a small external shape. Specifically, this embodiment can provide a highly reliable semiconductor device with a small external shape. Moreover, the electrodes 14 can be disposed in a reduced space by arranging the electrodes 14 in rows and columns. Therefore, a semiconductor device with a further reduced external shape can be provided.

The size of the semiconductor chip 10 can be further reduced by arranging the I/O cells in rows and columns. Specifically, the area occupied by the I/O cells can be reduced and the integrated circuit 12 of the semiconductor chip 10 can be designed with a reduced area by arranging the I/O cells in rows and columns. Therefore, the size of the semiconductor chip 10 can be further reduced. In this case, the electrode 14 may be formed to overlap at least part of the I/O cell. This makes it unnecessary to provide a region for forming the electrode 14 outside the I/O cell region. This also makes it unnecessary to provide a wiring region for connecting the I/O cell and the electrode 14. Therefore, the size of the semiconductor chip 10 can be further reduced. As described above, the semiconductor device 1 can be mounted without applying a force to the electrode 14. Therefore, the reliability of the semiconductor device can be ensured even if the electrode 14 is formed on the I/O cell.

According to the semiconductor device 1, a highly versatile semiconductor device can be provided. In more detail, the semiconductor device 1 allows the electrical connection sections 30 to be formed at the same positions even if the semiconductor chips differ in the arrangement of the electrodes 14 (design of the integrated circuit 12). Therefore, semiconductor chips which differ in the design of the integrated circuit 12 can be mounted on one interconnect substrate. Or, the arrangement of the electrical connection sections 30 can be changed even if the semiconductor chip 10 has an integrated circuit 12 of the same design. Therefore, semiconductor chips in which the same type of integrated circuit is formed can be mounted on interconnect substrates of different designs.

FIG. 6 is a view illustrative of a semiconductor device according to a modification of an embodiment to which the invention is applied. In FIG. 6, the resin protrusion 20 and the interconnect 32 (electrical connection section 30) are omitted for convenience of illustration. In the semiconductor device according to this embodiment, all electrodes 60 of the semiconductor substrate 10 may be disposed at the intersection points of first imaginary straight lines 103 extending in parallel and second imaginary straight lines 104 extending in parallel. As shown in FIG. 6, the first and second imaginary straight lines 103 and 104 may be straight lines which perpendicularly intersect. The first and second imaginary straight lines may be respectively arranged at equal intervals. In more detail, the first imaginary straight lines 103 may be arranged at equal intervals. The second imaginary straight lines may also be arranged at equal intervals. In this case, the first imaginary straight lines 103 and the second imaginary straight line 104 may be arranged at the same intervals. Note that the first and second imaginary straight lines may be straight lines which diagonally intersect (not shown). In this case, the resin protrusion (not shown) may be disposed (only) in a region outside the region in which the electrodes 60 are formed. Note that the resin protrusion (not shown) may be disposed in a region inside the region in which the electrodes 60 are formed. This embodiment can also provide a semiconductor device which exhibits high reliability and can be reduced in size.

In another modification of an embodiment to which the invention is applied, the semiconductor device may have a semiconductor substrate in the shape of a wafer (not shown). In this case, the semiconductor substrate in the shape of a wafer includes regions in which the semiconductor chips 10 are respectively formed. The semiconductor substrate in the shape of a wafer has a configuration in which one of the above structures is formed in units of the regions in which the semiconductor chips 10 are respectively formed. The above semiconductor device including the semiconductor chip 10 can be provided by cutting the semiconductor substrate in the shape of a wafer into individual pieces.

Although only some embodiments of the invention have been described in detail above, those skilled in the art will readily appreciate that many modifications are possible in the embodiments without materially departing from the novel teachings and advantages of this invention. Accordingly, all such modifications are intended to be included within the scope of the invention.

## Claims

1. A semiconductor device comprising:
a semiconductor chip in which an integrated circuit is formed;
a plurality of electrodes formed on the semiconductor chip and arranged in a plurality of rows and a plurality of columns;
a plurality of resin protrusions formed on a surface of the semiconductor chip on which the electrodes are formed; and
a plurality of electrical connection sections formed on the resin protrusions and electrically connected to the electrodes.

2. The semiconductor device as defined in claim 1,
wherein the electrodes are disposed at intersection points of first imaginary straight lines extending in parallel with one another and second imaginary straight lines perpendicularly intersecting the first imaginary straight lines.

3. The semiconductor device as defined in claim 2,
wherein the semiconductor chip has a rectangular external shape; and
wherein the first and second imaginary straight lines are parallel to long or short sides of the semiconductor chip.

4. The semiconductor device as defined in any one of claims 1 to 3,
wherein the semiconductor chip has a rectangular external shape; and
wherein the resin protrusions extend in parallel to long or short sides of the semiconductor chip.

5. The semiconductor device as defined in claim 4,
wherein one of the resin protrusions is provided near one of the sides of the semiconductor chip.

6. The semiconductor device as defined in claim 4,
wherein two or more of the resin protrusions are provided near one of the sides of the semiconductor chip.

7. The semiconductor device as defined in any one of claims 1 to 6,
wherein a plurality of I/O cells arranged in a plurality of rows and a plurality of columns are formed on the semiconductor chip; and
wherein each of the electrodes is electrically connected to one of the I/O cells.

8. The semiconductor device as defined in claim 7,
wherein each of the electrodes covers at least part of corresponding one of the I/O cells.

9. The semiconductor device as defined in any one of claims 1 to 8,
wherein the electrodes cover at least part of the integrated circuit.
